# EUROPÄISCHE PATENTSCHRIFT

(11) **EP 2 140 512 B1**
(45) Veröffentlichungstag und Bekanntmachung des Hinweises auf die Patenterteilung: **09.01.2019**
(21) Anmeldenummer: 08748731.0
(22) Anmeldetag: 03.04.2008
(51) Int. Cl.: H01L 51/10, H01L 51/44, H01L 51/54

(54) **ELEKTRISCHES ORGANISCHES BAUELEMENT UND VERFAHREN ZU SEINER HERSTELLUNG**
ELECTRIC ORGANIC COMPONENT AND METHOD FOR THE PRODUCTION THEREOF
COMPOSANT ÉLECTRIQUE ORGANIQUE, ET SON PROCÉDÉ DE FABRICATION

(30) Priorität: 23.04.2007 DE 102007019081; 24.05.2007 DE 102007024153
(43) Veröffentlichungstag der Anmeldung: 06.01.2010
(73) Patentinhaber: OSRAM OLED GmbH, 93049 Regensburg (DE)
(72) Erfinder: SCHMID, Günter, 91334 Hemhofen (DE); GÖÖTZ, Britta, 93049 Regensburg (DE); HEUSER, Karsten, 91056 Erlangen (DE); SCHERER, Wolfgang, 86391 Leitershofen (DE); HERRMANN, Rudolf, 86156 Augsburg (DE); SCHEIDT, Ernst-Wilhelm, 86420 Diedorf/Biburg (DE)
(74) Vertreter: Epping - Hermann - Fischer
(86) Internationale Anmeldenummer: PCT/DE2008/000571
(87) Internationale Veröffentlichungsnummer: WO 2008/128503

(56) Entgegenhaltungen:
- EP-A- 1 083 776
- WO-A-2006/059745
- DE-A1- 4 318 310
- US-A1- 2002 051 894
- US-A1- 2002 197 415
- US-A1- 2006 186 804

## Beschreibung

Elektrisches organisches Bauelement und Verfahren zu seiner Herstellung
Die Erfindung betrifft ein elektrisches organisches Bauelement mit einem Substrat, einer ersten Elektrode, einer organischen Funktionsschicht auf der ersten Elektrode und einer zweiten Elektrode auf der organischen Funktionsschicht.

Elektrische organische Bauelemente, wie zum Beispiel organische Leuchtdioden (OLEDs), organische Solarzellen oder organische Photodetektoren, mit organischen Funktionsschichten weisen eine Effizienz und eine Lebensdauer auf, die unter anderem davon abhängen, wie gut die Ladungsträgerinjektion aus den Elektroden in die organische Funktionsschicht oder von der Funktionsschicht zu den Elektroden hin erfolgt.

US2002/051894 beschreibt ein organisches elektrolumineszierendes Bauelement mit einer Elektrode aus Rhenium und Rheniumoxiden.

Aufgabe der Erfindung ist es, ein elektrisches organisches Bauelement mit verbesserten Elektrodenmaterialien bereitzustellen, die einen verbesserten Ladungsträgertransport zwischen der Elektrode und einer organischen Funktionsschicht ermöglichen.

Diese Aufgabe wird durch ein elektrisches organisches Bauelement gemäß dem Anspruch 1 gelöst. Weitere Ausgestaltungen des elektrischen organischen Bauelements und ein Verfahren zu dessen Herstellung sind Gegenstand weiterer Ansprüche.

In einem elektrischen organischen Bauelement gemäß einem Ausführungsbeispiel der Erfindung weist die erste und/oder zweite Elektrode polymere Rheniumverbindungen auf. Ein solches elektrisches organisches Bauelement umfasst ein Substrat, eine erste Elektrode, eine organische Funktionsschicht auf der ersten Elektrode und eine zweite Elektrode auf der organischen Funktionsschicht.

Dadurch, dass die erste und/oder zweite Elektrode polymere Rheniumverbindungen aufweist, wird der Ladungsträgertransport zwischen der organischen Funktionsschicht des elektrisch organischen Bauelements und der Elektrode erleichtert, was zu einer Verbesserung der Effizienz und Lebensdauer des Bauelements führt.

Der Ausdruck "auf" in Bezug auf die Schichtenfolge in dem elektrischen organischen Bauelement bedeutet, dass sich beispielsweise die organische Funktionsschicht in direktem Kontakt mit der ersten Elektrode befinden kann, dass aber auch noch weitere Schichten zwischen der ersten Elektrode und der organischen Funktionsschicht vorhanden sein können.

Gemäß einer Weiterbildung der Erfindung ist die erste und/oder zweite Elektrode transparent. Dadurch kann je nach Verwendung des Bauelements beispielsweise sichtbares Licht durch die Elektroden hindurch emittiert werden oder Licht durch die Elektroden hindurch in die organische Funktionsschicht eingekoppelt werden.

Die erste und/oder zweite Elektrode umfasst polymere Rheniumverbindungen. Weiterhin können die polymeren Rheniumverbindungen organometallische Rheniumoxide oder organische Rhenium-oxo-verbindungen umfassen. Die polymeren Rheniumoxide sind beispielsweise aus einer Gruppe ausgewählt, die Poly-Alkyltrioxorhenium, substituiertes oder unsubstituiertes Poly-Cyclopentadienyltrioxorhenium und Poly-Trioxorhenium mit zumindest einem aromatischen Substituenten umfasst. Die polymere Rheniumverbindung kann Poly-Methyltrioxorhenium (Poly-MTO) umfassen. Die genannten Verbindungen sind leicht durch Polymerisation zu erhalten und zeichnen sich durch Stabilität aus. Weiterhin bieten sie eine Alternative zu herkömmlich verwendeten Materialien für Elektroden.

Weiterhin können die polymeren Rheniumverbindungen Dotierstoffe aufweisen. Die Dotierstoffe können die Eigenleitfähigkeit der Rheniumverbindungen erhöhen und beispielsweise aus einer Gruppe ausgewählt sein, die Tetrathiafulvalen (TTF), Bis-(ethylendithio)-tetrathiafulvalen (BEDT-TTF), SbF₃, V, Mo und W umfasst. Eine Dotierung der polymeren Rheniumverbindungen verbessert weiterhin den Ladungstransport zwischen der Elektrode und der organischen Funktionsschicht, z. B. die Ladungsträgerinjektion von der Elektrode in die organische Funktionsschicht.

In einer weiteren Ausführungsform ist zwischen der organischen Funktionsschicht und der ersten und/oder zweiten Elektrode eine dotierte elektrisch halbleitende Schicht vorhanden. Die dotierte elektrisch halbleitende Schicht kann einen Dotierstoff aufweisen, der Rheniumverbindungen, z. B. Rhenium-oxo-verbindungen umfasst.

In einer weiteren Ausführungsform umfasst der Dotierstoff eine ReO₃-Einheit an die ein Rest M gebunden ist, der organisch sein kann. Die ReO₃-Einheit weist eine geringe Oxidationskraft auf, so dass sie in Verbindung mit organischen Resten stabil ist. Der Rest M kann an die ReO₃-Einheit σ-gebunden sein. Aufgrund der außerordentlichen Redox-Stabilität der ReO₃-Einheit ist eine metallorganische Verbindung mit einem σ-gebundenen organischen Rest stabil. Weiterhin eignet sich die ReO₃-Einheit, an die ein organischer Rest M gebunden ist, für die Dotierwirkung, da sie einen besonderen Lewis-sauren Charakter hat.

Der Rest M kann aus einer Gruppe ausgewählt sein, die verzweigte und unverzweigte gesättigte aliphatische Gruppen, verzweigte und unverzweigte ungesättigte aliphatische Gruppen, Aromaten, Anionen von Carbonsäuren, Halogene, Stanylreste und Silylreste umfasst. Bei den gesättigten aliphatischen Gruppen kann es sich beispielsweise um Methyl-, Ethyl-, und Propylgruppen, aber auch um substituierte Aliphaten, wie beispielsweise Benzyl- oder Fluoro-Aliphaten, handeln. Beispiele für Aromaten können Phenyl, Indenyl, und Mesityl sein. Acetat, Trifluoroacetat und Toluolsulfonat sind beispiele für Anionen der Carbonsäuren beziehungsweise organischen Säuren. Als Silylrest kann beispielsweise Trimethylsilyl eingesetzt werden, und als Halogene beispielsweise Chlor-, Brom-, und Iod-Reste. Diese Reste M können mit der ReO₃-Einheit eine stabile σ-Bindung eingehen. Weiterhin können die aliphatischen Gruppen, die Aromaten und die Anionen der Carbonsäuren weitere Substituenten aufweisen. Günstigerweise handelt es sich dabei um Donorsubstituenten, wie beispielsweise Amine, Phosphane oder Thiole. Diese Substituenten können die p-dotierende Wirkung des Dotierstoffs verstärken.

In einer weiteren Ausführungsform kann der Rest M an die ReO₃-Einheit π-gebunden sein. Weiterhin kann der Rest M unsubstituiertes oder substituiertes Cyclopentadienyl umfassen, das die Strukturformel (C₅RₓH₅₋ₓ) aufweist, mit x = 1 bis 5. R kann dabei Substituenten umfassen, die unabhängig voneinander einen Alkylrest, zum Beispiel Methyl-, Ethyl- oder einen Arylrest, zum Beispiel Phenylrest umfassen. Auch die Rheniumoxide mit π-gebundenen organischen Resten M bilden stabile Verbindungen und sind Lewis-sauer.

Gemäß einer Weiterbildung der Erfindung weist die elektrisch halbleitende Schicht ein Matrixmaterial auf, in dem die Rheniumverbindungen als Dotierstoffe vorhanden sind. Weiterhin kann das Matrixmaterial durch den Dotierstoff p-dotiert sein. Dadurch kann in dem Matrixmaterial eine positive Ladung oder Partialladung in den, den Ladungsträgertransport vermittelnden Energieniveaus erzeugt werden. Dabei kann bei einer p-Dotierung das niedrigste nicht besetzte Orbital (LUMO) des Dotierstoffes energetisch nahe oder sogar unter dem höchsten besetzten Orbital (HOMO) des Matrixmaterials lokalisiert sein, mit der Folge, dass ein Elektron vom HOMO des Matrixmaterials auf das LUMO des Dotierstoffes übergeht und so eine positive Ladung beziehungsweise Partialladung im Matrixmaterial erzeugt wird.

Gemäß einer weiteren Ausführungsform ist das Matrixmaterial ein loch- beziehungsweise defektelektronentransportierendes Material, das zum Beispiel Stickstoff, Sauerstoff, Schwefel, Selen, Phosphor und Arsengruppen, sowie beliebige Kombinationen davon enthalten kann, die gut Elektronen beziehungsweise negative Partialladungen auf einen p-Dotierstoff übertragen können.

Weiterhin kann das Material der Matrix aus einer Gruppe ausgewählt sein, die Phenantrolinderivate, Imidazolderivate, Triazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie beliebige Kombinationen der genannten Materialien umfasst. Beispiele für Strukturformeln von Matrixmaterialien auf der Basis von Triarylaminen und Carbazoylverbindungen sind:
-N,N'-diphenyl-N,N'-(3-methylphenyl)-1,1'-biphenyl-4,4'-diamin (TPD, Formel 1)
-4,4',4"-Tris(N-(3-methylphenyl)-N-phenyl-amino)-triphenylamin (m-MTDATA, Formel 2)
-2,9-Dimethyl-4,7-diphenyl-1,10-phenantrolin (BCP, Formel 3)
-4,4',4"-Tris(N-(1-naphthyl)-N-phenyl-amino)-triphenylamin (1-TNATA, Formel 4)
-2,2',7,7'-Tetrakis(diphenylamin)-9,9'-spirobifluoren,(Spiro-TAD, Formel 5)
-4,4'-N,N'-Dicarbazolbiphenyl (CBP, Formel 6)
-(N,N'-Bis(naphtalen-1-yl)-N,N'-Bis(phenyl)benzidin) (α-NPD, Formel 7)

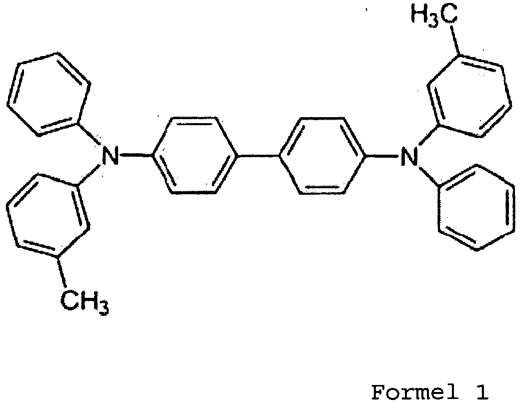

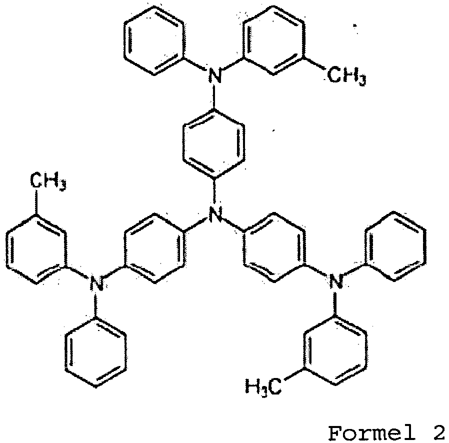

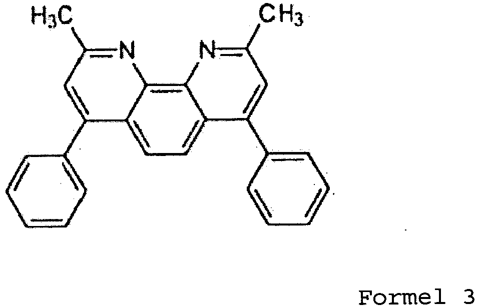

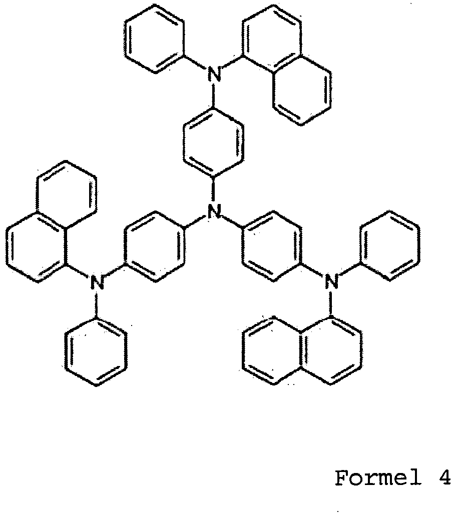

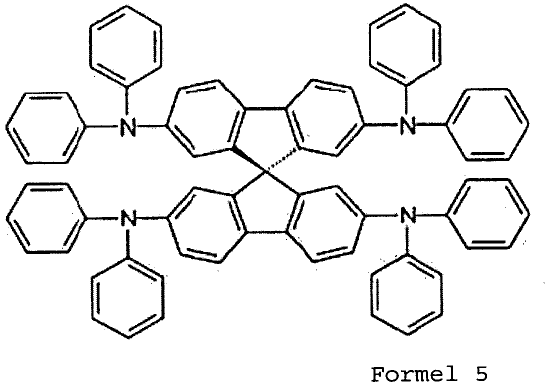

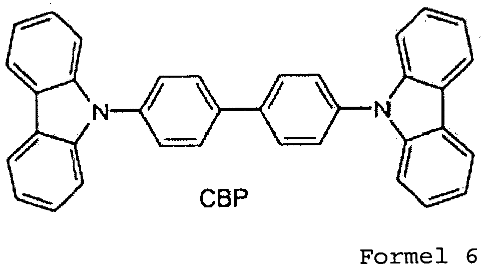

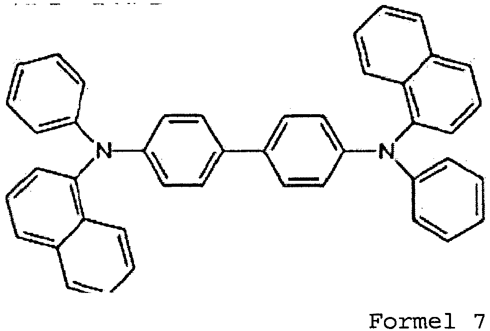

Ein Beispiel für Phenantrolinderivate ist 4,7-Diphenyl-1,10-Phenantrolin (Bphen), für Imidazolderivate 1,3,5-Tris-(1-phenyl-1H-benzimidazol-2-yl)-benzen (TPBi), für Triazolderivate 3-Phenyl-4-(1'-naphthyl)-5-phenyl-1,2,4-triazol (TAZ). Als Oxazolderivat kann beispielsweise ((2,4-Biphenylyl)-5-(4-tert-butylphenyl)-1,3,4-oxadiazol) (Bu-PBD) eingesetzt werden. Beispiele für Phenyl-haltige Verbindungen und Verbindungen mit kondensierten Aromaten sind Naphthyl-phenyl-diamin (NPD), (4,4'-Bis(2,2-diphenyl-ethen-1-yl)-diphenyl) (DPVBi), Rubren, (N,N'-Bis(naphtalen-1-yl)-N,N'-Bis(phenyl)benzidin) (α-NPD), (4,4',4"-Tris(N-(naphth-1-yl)-N-phenyl-amino)triphenylamin) (1-TNATA). Als Carbazol-haltige Verbindungen können z. B. (4,4'-Bis(9-ethyl-3-carbazovinylen)1,1'-biphenyl) (BCzVBi) aber auch kleinere Carbazolderivate wie beispielsweise (4,4'-Bis(carbazol-9-yl)biphenyl) (CBP) eingesetzt werden. Diese Verbindungen haben wie bereits oben genannt Elektronen-Donorgruppen wie beispielsweise Stickstoff, Sauerstoff, oder Schwefel, die besonders geeignet für die Dotierung mit Rheniumverbindungen, z. B. Rhenium-oxo-verbindungen sind. Weiterhin können die Rheniumverbindungen als Lewis-Säure Elektronen bzw. negative Ladungen oder Partialladungen vom Matrixmaterial übernehmen und somit eine p-Dotierung bewirken.

Nach einer weiteren Ausbildungsform bilden der Dotierstoff und das Matrixmaterial einen Komplex. Der Dotiermechanismus wird beispielsweise in Formel 8 verdeutlicht:

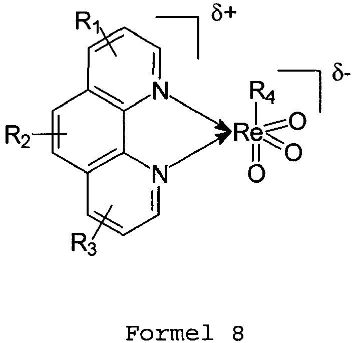

Hier wird die Dotierwirkung der ReO₃-Einheit mit σ- oder π-gebundenen organischen Resten gezeigt. Die Reste R₁, R₂ und R₃ stehen beispielhaft für die Substitutionsmuster an den Aromaten. Es können auch mehr oder weniger Substituenten vorhanden sein. Die Auswahl an Substituenten ist nicht beschränkt. Auch die ReO₃-Einheit mit σ- oder π-gebundenen organischen Resten bilden stabile Komplexe, die über die Partialladungen δ⁺ und δ⁻ mit dem Matrixmaterial stabilisiert sind. Die Komplexe der Formel 8 sind thermisch bis circa 400°C stabil und eignen sich daher gut für die Dotierfunktion in elektrisch organischen Bauelementen, auch wenn diese bei hohen Temperaturen betrieben werden. Das Molverhältnis Matrix zu Dotierstoff kann dabei zwischen 0,001 und 1 variiert werden.

In einer weiteren Ausführungsform umfasst die elektrisch halbleitende Schicht eine Ladungstransport-/Ladungsinjektionsschicht beziehungsweise hat die elektrisch halbleitende Schicht die Funktion einer Ladungstransport-/Ladungsinjektionsschicht. Die elektrisch halbleitende Schicht kann Ladungen von oder zur ersten und/oder zweiten Elektrode transportieren. Weiterhin kann es sich bei der Ladungstransport-/Injektionsschicht um eine Lochtransport-/Lochinjektionsschicht handeln. In diesem Fall können positive Ladungen von der ersten oder zweiten Elektrode hin zur organischen Funktionsschicht transportiert werden unter der Bedingung, dass die erste oder zweite Elektrode als Anode geschaltet ist.

In einer weiteren Ausführungsform ist das Bauelement aus einer Gruppe ausgewählt, die Feldeffekttransistoren, Solarzellen und Fotodetektoren umfasst.

Weiterhin kann das Bauelement eine Leuchtdiode umfassen. Die Dotierung der elektrisch halbleitenden Schicht in einer Leuchtdiode kann zu erhöhter Lumineszenz, Effizienz und Lebensdauer führen.

In einer weiteren Ausführungsform umfasst die organische Funktionsschicht der Leuchtdiode eine strahlungsemittierende Schicht, die Strahlung im infraroten bis ultravioletten Bereich, zum Beispiel Licht im sichtbaren Wellenlängenbereich emittieren kann (organische lichtemittierende Vorrichtung OLED). Dabei kommt es bei Anlegen eines elektrischen Feldes an der ersten und zweiten Elektrode zur Aussendung von Strahlung aus der elektrolumineszierenden organischen Funktionsschicht aufgrund der Rekombination von Löchern und Elektronen (Elektrolumineszenz). Je nachdem, welche der Elektroden transparent für die emittierte Strahlung ausgebildet ist, kann Licht durch die erste Elektrode und/oder die zweite Elektrode aus der Vorrichtung emittiert werden.

Weiterhin wird ein Verfahren zur Herstellung eines elektrischen organischen Bauelements mit den oben genannten Merkmalen bereitgestellt. Das Verfahren umfasst die Verfahrensschritte A) Bereitstellen eines Substrats, B) Erzeugen einer funktionellen Schichtanordnung auf dem Substrat, wobei die Schichtanordnung eine erste Elektrode, eine auf der ersten Elektrode angeordnete organische Funktionsschicht und eine auf der Funktionsschicht angeordnete zweite Elektrode umfasst. Die erste und/oder zweite Elektrode umfasst polymere Rheniumverbindungen. In einer weiteren Ausführungsform umfasst der Verfahrensschritt B) die Verfahrensschritte B1) Erzeugen der ersten Elektrode auf dem Substrat, B2) Erzeugen der organischen Funktionsschicht auf der ersten Elektrode und B3) Erzeugen der zweiten Elektrode auf der organischen Funktionsschicht.

Weiterhin können in den Verfahrensschritten B1) und/oder B3) monomere Rheniumverbindungen auf das Substrat und/oder auf der organischen Funktionsschicht aufkondensiert und anschließend erhitzt werden, wobei eine Polymerisation der Rheniumverbindungen erfolgt, wobei die erste und/oder zweite Elektrode gebildet wird. Weiterhin können die monomeren Rheniumverbindungen aus einer Gruppe ausgewählt sein, die Alkyltrioxorhenium, substituiertes oder unsubstituiertes Cyclopentadienyltrioxorhenium und Trioxorhenium mit zumindest einem aromatischen Substituenten umfasst. Die Rheniumverbindungen können weiterhin Dotierstoffe aufweisen, die aus einer Gruppe ausgewählt sind, die V, Mo und W umfasst. Der Anteil an Dotierstoffen in den Rheniumverbindungen beträgt dabei einen Anteil von weniger als 20%.

In einer weiteren Ausführungsform werden im Verfahrensschritt B1) und/oder im Verfahrensschritt B3) in die polymerisierten Rheniumverbindungen Dotierstoffe eingelagert. Die Dotierstoffe können aus einer Gruppe ausgewählt sein, die Tetrathiafulvalen, Bis-(ethylendithio)-tetrathiafulvalen und SbF₃ umfasst. Der Zusatz von Dotierstoffen bewirkt, dass die Ladungsinjektion von der Elektrode in organische Funktionsschichten und umgekehrt noch verbessert wird und die Eigenleitfähigkeit der Elektrode erhöht wird.

In einer weiteren Ausführungsform wird in einem auf den Verfahrensschritt B1) und/oder auf den Verfahrensschritt B2) folgenden Verfahrensschritt C) eine elektrisch halbleitende Schicht auf der ersten Elektrode und/oder auf der organischen Funktionsschicht erzeugt. Im Verfahrensschritt C) können Rheniumverbindungen als Dotierstoffe und ein Matrixmaterial gleichzeitig auf der ersten Elektrode und/oder auf der organischen Funktionsschicht abgeschieden werden. Eine halbleitende Schicht zwischen der organischen Funktionsschicht und der ersten und/oder zweiten Elektrode, die eine Dotierung aufweist, weist eine erhöhte Leitfähigkeit auf im Vergleich zu nicht dotierten elektrisch halbleitenden Schichten. Weiterhin kann im Verfahrensschritt C) das Molverhältnis zwischen den Rheniumverbindungen und dem Matrixmaterial mittels des Molverhältnisses zwischen Abscheidungsrate der Rheniumverbindung und Abscheidungsrate des Matrixmaterials eingestellt werden. Damit kann das Verhältnis Matrixmaterial zu Rheniumverbindung beliebig zwischen 0,001 und 1 variiert werden. Weiterhin kann im Verfahrensschritt C) während der Erzeugung der elektrisch halbleitenden Schicht das Molverhältnis Matrixmaterial zu Rheniumverbindung variiert werden, so dass ein Gradient des Molverhältnisses von Matrixmaterial zu Rheniumverbindung innerhalb der abgeschiedenen Schicht entsteht. Damit können in der elektrisch halbleitenden Schicht die leitenden Eigenschaften in Abhängigkeit von der Schichtdicke eingestellt werden.

In einer weiteren Ausführungsform wird im Verfahrensschritt C) die halbleitende Schicht mit einer Schichtdicke von 30 nm abgeschieden. Alternativ zur gleichzeitigen Abscheidung von Matrixmaterial und Rheniumverbindungen kann auch zuerst eine reine Schicht aus Rheniumverbindungen abgeschieden werden und anschließend das Matrixmaterial. Die reine Rheniumverbindungsschicht hat dabei eine Schichtdicke von weniger als 10 nm. Die Dotierwirkung der Rheniumverbindung wirkt sich hier vornehmlich an der Grenzfläche zwischen erster und/oder zweiter Elektrode und elektrisch halbleitender Schicht aus. An der Grenzfläche kann sich das Matrixmaterial teilweise auch in die polymeren Rheniumverbindungen der ersten und/oder zweiten Elektrode einlagern und eine Interkalationsverbindung bilden.

In einer weiteren Ausführungsform kann auf die erste und/oder zweite Elektrode eine weitere Schicht mit weiterem Elektrodenmaterial abgeschieden werden. Als Materialien für diese zusätzlichen Elektrodenschichten können Materialien ausgewählt werden, die aus einer Gruppe ausgewählt sind, die Metalle, Metalllegierungen, organische leitende Materialien und Metalloxide umfasst.

In einer weiteren Ausführungsform wird im Verfahrensschritt A) ein Glassubstrat bereitgestellt. Weiterhin kann die erste Elektrode als Anode ausgeführt sein. In einer weiteren Ausführungsform kann die erste Elektrode als Kathode ausgeführt sein. Im Falle der Verwendung einer Leuchtdiode als organisches elektrisches Bauelement kann Strahlung, zum Beispiel sichtbares Licht, durch das Substrat emittiert werden.

Anhand der Figur und der Ausführungsbeispiele soll die Erfindung näher erläutert werden:

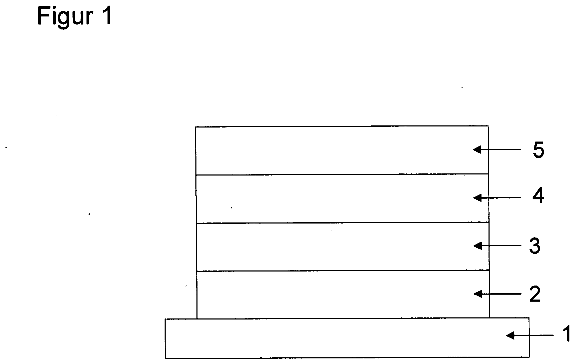

Figur 1 zeigt eine schematische Seitenansicht des elektrischen organischen Bauelements.

Figur 1 zeigt die schematische Seitenansicht einer Ausführungsform des erfindungsgemäßen elektrischen organischen Bauelements. Auf einem Substrat 1 befindet sich eine erste Elektrode 2, auf dieser eine erste elektrisch halbleitende Schicht 3, darauf eine organische Funktionsschicht 4 und schließlich eine zweite Elektrode 5. Das Substrat kann beispielsweise ein Glassubstrat sein. Die erste und/oder zweite Elektrode umfasst polymere Rheniumverbindungen, beispielsweise Rhenium-oxo-verbindungen, die aus einer Gruppe ausgewählt sind, die Poly-Alkyltrioxorhenium, substituiertes oder unsubstituiertes Poly-Cyclopentadienyltrioxorhenium und Poly-Trioxorhenium mit zumindest einem aromatischen Substituenten umfasst. Beispielsweise umfasst die polymere Rhenium-oxo-verbindung der ersten und/oder zweiten Elektrode Poly-Methyltrioxorhenium (Poly-MTO). Die polymeren Rhenium-oxo-verbindungen können Dotierstoffe aufweisen, die aus einer Gruppe ausgewählt sind, die Tetrathiafulvalen, Bis-(ethylendithio)-tetrathiafulvalen, SbF₃, V, Mo und W umfasst. Die erste und/oder zweite Elektrode kann weiterhin eine weitere Beschichtung aufweisen (hier nicht gezeigt) die aus einem Material besteht, das aus einer Gruppe ausgewählt ist, die Metalle und deren Legierungen, Edelmetalle und deren Legierungen, Metalloxide und dotierte Polymere umfasst. Beispielsweise kann eine solche Beschichtung der ersten und/oder zweiten Elektrode Indiumzinnoxid (ITO) umfassen oder Aluminium oder AlMg₃. Die erste elektrisch halbleitende Schicht 3 umfasst ein Matrixmaterial sowie einen Dotierstoff. Das Matrixmaterial kann organische Materialien umfassen, die E-lektronendonorfunktionen aufweisen und kann aus einer Gruppe ausgewählt sein, die Phenanthrolinderivate, Imidazolderivate, Triazolderivate, Oxadiazolderivate, Phenyl-haltige Verbindungen, Verbindungen mit kondensierten Aromaten, Carbazol-haltige Verbindungen, Fluorenderivate, Spirofluorenderivate und Pyridin-haltige Verbindungen sowie beliebige Kombinationen der genannten Materialien umfasst. Beispiele für solche Matrixmaterialien sind Bphen, BCP, TPBi, TAZ, Bu-PBD, DPVBi, Rubren, α-NPD (NPB), 1-TNATA, CBP, BCzVBi, wobei Rubren und BCzVBi auch als emittierende Materialien eingesetzt werden können. Der Dotierstoff umfasst Rheniumverbindungen, die Rheniumoxide, metallorganische Derivate von Rheniumoxiden und Rheniumoxyhalogenide sowie Mischungen daraus sein können. Weiterhin kann der Dotierstoff eine ReO₃-Einheit umfassen, an die ein Rest M gebunden ist, der organisch sein kann. Der Rest M kann an die ReO₃ Einheit σ-gebunden sein. In diesem Fall umfasst der Rest M gesättigte aliphatische Gruppen, ungesättigte aliphatische Gruppen, Aromaten, Anionen der Carbonsäuren, Halogene, Stanylreste und Silylreste. Die aliphatischen Gruppen, Aromaten und Anionen der Carbonsäuren können weiterhin Substituenten aufweisen. Der Rest M kann an die ReO₃-Einheit π-gebunden sein. In diesem Fall kann der Rest M unsubstituiertes oder substituiertes Cyclopentadienyl (C₅RₓH₅₋ₓ) umfassen, wobei x = 1-5 und R unabhängig voneinander ein Methyl-, Ethyl- und Phenyl-Rest sein kann. Der Dotierstoff und das Matrixmaterial bilden einen Komplex. Dieser zeichnet sich durch besondere Temperaturstabilität bis zu 400°C sowie leichte Sublimierbarkeit und Prozessierbarkeit aus. Das Molverhältnis von Matrixmaterial zu Dotierstoff kann je nach Bedarf zwischen 0,001 und 1 variiert werden. Weiterhin kann innerhalb der elektrisch halbleitenden Schicht 3 das Molverhältnis Matrix zu Dotierstoff variiert werden, so dass ein Gradient entsteht. Die elektrisch halbleitende Schicht 3 kann eine Ladungstransport-/Ladungsinjektionsschicht umfassen, zum Beispiel eine Lochtransport-/Lochinjektionsschicht. Weiterhin kann die erste Elektrode 2 als Anode geschaltet sein. Die organische Funktionsschicht 4 kann eine lichtemittierende Schicht umfassen. Das in Figur 1 dargestellte elektrische organische Bauelement kann eine organische Leuchtdiode (OLED) sein. Weiterhin kann es ein Feldeffekttransistor, eine Solarzelle oder Photodetektoren umfassen. Im Falle eines Feldeffekttransistors sind eine Source-Elektrode, eine Gate-Elektrode und eine Drain-Elektrode vorhanden (hier nicht gezeigt), wobei die Source- und Drain-Elektroden dotiert sind und zwischen ihnen ein undotierter oder dotierter Halbleiter liegt.

Die Einführung von Rheniumverbindungen, z. B. Rhenium-oxo-verbindungen, als p-Dopanden in der elektrisch halbleitenden Schicht 3 führt zu verbesserten Leitfähigkeiten der elektrisch halbleitenden Schicht und zu einer stabilen p-Dotierung, die die Effizienz und Lebensdauer des Bauelements erhöht und die bewirkt, dass das Material der ersten und/oder zweiten Elektrode unabhängig gewählt werden kann.

Die Verwendung von polymeren Rheniumverbindungen, z. B. Rhenium-oxo-verbindungen, in der ersten und/oder zweiten Elektrode führt weiterhin zu verbesserten Leitfähigkeiten und Ladungsinjektionen von den Elektroden in die elektrisch halbleitende Schicht oder in die organische Funktionsschicht und umgekehrt, was zu einer erhöhten Effizienz und Lebensdauer des Bauelements führt.

### Ausführungsbeispiel 1:

Als Ausführungsbeispiel soll die Herstellung einer Elektrode aus Methyltrioxorhenium (MTO) angegeben werden. In einem Hochvakuumrezipienten (Basisdruck < 10⁻⁵ mbar) ist ein kühl- und heizbarer Substratteller (-30°C bis -50°C bis maximal 200°C) eingebaut. Über einen auf circa 60°C vorgeheizten Einlass wird MTO eingeleitet. Alternativ kann MTO auch über ein inertes Trägergas eingeleitet werden. MTO wird auf eine Glas- oder Quarzscheibe oder eine Kunststofffolie aufkondensiert, die sich auf dem auf -30°C gekühlten Substratteller befindet. Nachdem eine Schichtdicke von circa 150 nm an MTO erreicht wurde, wird der Rezipient mit trockenen Inertgas auf einen Druck von circa 10 mbar bis 900 mbar gebracht. Anschließend wird der halbharte Feststoff langsam mit 0,1 bis 20 K/min über dem Schmelzpunkt von 108°C bis 250°C erhitzt. Hierbei findet unter Abspaltung von Kohlenwasserstoffen (hauptsächlich Methan) die Polymerisation statt. Es können auch weitere Stoffe zur Dotierung der Elektrode selbst mit einkondensiert werden, beispielsweise TTF, BEDT-TTF und SbF₃. Im Anschluss an die Polymerisation ist die Abscheidung der Elektrode abgeschlossen. Sie kann gegebenenfalls noch durch einen Nachtemperschritt bei 140°C bis 250°C verfestigt werden. Das beschriebene Verfahren ist dazu geeignet, die erste Elektrode auf dem Substrat abzuscheiden, weiterhin ist es möglich mit diesem Verfahren die zweite Elektrode nach der Aufbringung der übrigen Schichten abzuscheiden. Im Falle der Herstellung von Leuchtdioden kann somit sowohl eine top-emittierende Leuchtdiode als auch eine bottom-emittierende Leuchtdiode hergestellt werden.

### Ausführungsbeispiel 2:

In einem weiteren Ausführungsbeispiel wird in einem Hochvakuumrezipienten (Basisdruck < 10⁻⁷ mbar) der Substratteller mit eingespannter Glasplatte auf -10°C gekühlt. Über einen auf circa 60°C vorgeheizten Einlass wird MTO eingeleitet. MTO wird auf die Glasscheibe aufkondensiert, bis eine Schichtdicke von 150 nm an MTO erreicht werden. Anschießend wird der Rezipient mit trockenem Argon auf einen Druck von circa 250 mbar gebracht. Dann wird der halbharte Feststoff langsam mit 3 K/min über den Schmelzpunkt von 106°C auf 110°C erhitzt, wobei die Polymerisation zu Poly-MTO unter Abspaltung von Methan stattfindet. Im Anschluss an die Polymerisation ist die Abscheidung der Elektrode abgeschlossen. Dieses Substrat wird aus dem Vakuumrezipienten genommen und fotolithographisch strukturiert. Im Vakuumrezipienten befindet sich auch eine Quelle mit elektrisch beheizbarem Behälter mit Deckel, in den NPB eingefüllt wird. Anschließend wird die Glasplatte mit den strukturierten Poly-MTO-Elektroden auf den Substrathalter circa 25 cm entfernt von der NPB-Quelle befestigt. Das NPB und das MTO werden gleichzeitig auf der Elektrode abgeschieden. Es wird eine Gesamtschichtdicke von 30 nm der elektrisch halbleitenden Schicht abgeschieden. Anschließend wird noch 10 nm reines NPB als Elektronenblockierschicht abgeschieden. Im Anschluss können weitere Schichten des elektrischen Bauelements abgeschieden werden. In diesem Beispiel kann die Dotierkonzentration der elektrisch halbleitenden Schicht 50% betragen. Weiterhin kann die Dotierkonzentration ein Prozent betragen. Als Matrixmaterial können weiterhin Bphen, TAZ, oder Naphthalintetracarbonsäureanhydrid verwendet werden. Statt MTO können weiterhin Cyclopentadienyltrioxorhenium oder Pentamethylcyclopentadienyltrioxorhenium verwendet werden. In der elektrisch halbleitenden Schicht kann ein Dotiergradient des Molverhältnisses von 10 zu 1 bis 10000 zu 1 erzeugt werden. Nach der Polymerisation des Elektrodenmaterials kann ein Verfestigungsschritt bei 130°C durchgeführt werden. Nach diesem Verfahren kann eine topemittierende Leuchtdiode oder eine bottomemittierende Leuchtdiode erzeugt werden.

Das in Figur 1 gezeigte Beispiel und die Ausführungsbeispiele zur Herstellung können beliebig variiert werden. Es ist weiterhin zu berücksichtigen, dass sich die Erfindung nicht auf diese Beispiele beschränkt, sondern weitere, in den Ansprüchen aufgeführte Ausgestaltungen zulässt.

## Patentansprüche

1. Elektrisches organisches Bauelement, aufweisend
- ein Substrat (1),
- eine erste Elektrode (2),
- eine organische Funktionsschicht (4) auf der ersten Elektrode (2),
und
- eine zweite Elektrode (5) auf der organischen Funktionsschicht (4),
wobei die erste (2) und/oder zweite Elektrode (5) polymere Rheniumverbindungen umfasst.

2. Bauelement nach dem vorhergehenden Anspruch, wobei die polymeren Rheniumverbindungen aus einer Gruppe ausgewählt sind, die Poly-Alkyltrioxorhenium, , substituiertes oder unsubstituiertes Poly-Cyclopentadienyltrioxorhenium und Poly-Trioxorhenium mit zumindest einem aromatischen Substituenten umfasst.

3. Bauelement nach einem der vorhergehenden Ansprüche, wobei die polymere Rheniumverbindung Poly-Methyltrioxorhenium ist.

4. Bauelement nach einem der Ansprüche 1 bis 3, wobei die polymeren Rheniumverbindungen Dotierstoffe aufweisen.

5. Bauelement nach einem der vorhergehenden Ansprüche, wobei zwischen der organischen Funktionsschicht (4) und der ersten (2) und/oder zweiten Elektrode (5) eine dotierte elektrisch halbleitende Schicht (3) vorhanden ist.

6. Bauelement nach dem vorhergehenden Anspruch, wobei die dotierte elektrisch halbleitende Schicht (3) einen Dotierstoff aufweist, der Rheniumverbindungen umfasst.

7. Bauelement nach dem vorhergehenden Anspruch, wobei der Dotierstoff eine ReO₃-Einheit umfasst, an die ein Rest M gebunden ist.

8. Bauelement nach dem vorhergehenden Anspruch, wobei der Rest M an die ReO₃-Einheit σ-gebunden oder π-gebunden ist.

9. Bauelement nach einem der Anspruch 7, wobei der Rest M aus einer Gruppe ausgewählt ist, die verzweigte oder unverzweigte gesättigte aliphatische Gruppen, verzweigte oder unverzweigte ungesättigte aliphatische Gruppen, Aromaten, Anionen von Carbonsäuren, Halogene, Stannylreste, Silylreste und π-gebundenes, unsubstituiertes oder substituiertes Cyclopentadienyl umfasst.

10. Bauelement nach einem der Ansprüche 5 bis 9, wobei die elektrisch halbleitende Schicht (3) ein Matrixmaterial aufweist, in dem die Rheniumverbindungen als Dotierstoffe vorhanden sind und die Rheniumverbindungen und das Matrixmaterial einen Komplex bilden.

11. Bauelement nach einem der Ansprüche 5 bis 10, wobei die elektrisch halbleitende Schicht (3) eine Ladungstransport-/Ladungsinjektionsschicht umfasst.

12. Bauelement nach einem der vorhergehenden Ansprüche, wobei das Bauelement als Feldeffekttransistor, Solarzelle oder Photodetektor ausgebildet ist oder eine Leuchtdiode umfasst.

13. Verfahren zur Herstellung eines elektrischen organischen Bauelements gemäß den Ansprüchen 1 bis 12, umfassend die Verfahrensschritte
A) Bereitstellen eines Substrats (1),
B) Erzeugen einer funktionellen Schichtanordnung auf dem Substrat (1), wobei die Schichtanordnung eine erste Elektrode (2), eine auf der ersten Elektrode angeordnete organische Funktionsschicht (4) und eine auf der Funktionsschicht angeordnete zweite Elektrode (5) umfasst, wobei die erste (2) und/oder zweite Elektrode (5) polymere Rheniumverbindungen umfasst.

14. Verfahren nach dem vorhergehenden Anspruch, wobei der Verfahrensschritt B) umfasst:
B1) Erzeugen der ersten Elektrode (2) auf dem Substrat (1),
B2) Erzeugen der organischen Funktionsschicht (4) auf der ersten Elektrode (2),
B3) Erzeugen der zweiten Elektrode (5) auf der organischen Funktionsschicht (4),
wobei im Verfahrensschritt B1) und/oder im Verfahrensschritt B3) monomere Rheniumverbindungen auf das Substrat (1) und/oder auf der organischen Funktionsschicht (4) aufkondensiert und anschließend erhitzt werden, wobei eine Polymerisation der Rheniumverbindungen erfolgt und die erste (2) und/oder zweite Elektrode (5) gebildet wird.

15. Verfahren nach Anspruch 14, wobei in einem auf den Verfahrensschritt B1) und/oder auf den Verfahrensschritt B2) folgenden Verfahrensschritt C) eine elektrisch halbleitende Schicht (3) auf der ersten Elektrode (2) und/oder auf der organischen Funktionsschicht (4) erzeugt wird und wobei Rheniumverbindungen als Dotierstoffe und ein Matrixmaterial gleichzeitig auf der ersten Elektrode (2) und/oder auf der organischen Funktionsschicht (4) abgeschieden werden, wobei die elektrisch halbleitende Schicht (3) gebildet wird.

## Claims

1. Electrical organic component having
- a substrate (1),
- a first electrode (2),
- an organic functional layer (4) on the first electrode (2), and
- a second electrode (5) on the organic functional layer (4), wherein the first (2) and/or the second (5) electrode comprises rhenium compounds.

2. Component according to the preceding claim, wherein the polymeric rhenium oxides are selected from the group comprising polyalkyltrioxorhenium, substituted or unsubstituted polycyclopentadienyltrioxorhenium and polytrioxorhenium with at least one aromatic substituent.

3. Component according to one of the preceding claims, wherein the polymeric rhenium compound is polymethyltrioxorhenium.

4. Component according to one of claims 1 to 3, wherein the polymeric rhenium compounds comprise dopants.

5. Component according to one of the preceding claims, wherein a doped electrically semiconducting layer (3) is present between the organic functional layer (4) and the first (2) and/or second (5) electrode.

6. Component according to the preceding claim, wherein the doped electrically semiconducting layer (3) comprises a dopant that comprises rhenium compounds.

7. Component according to the preceding claim, wherein the dopant consists of an ReO₃ unit to which a residue M is bonded.

8. Component according to the preceding claim, wherein the residue M is σ-bonded or π-bonded to the ReO₃ unit.

9. Component according to claim 7, wherein the residue M is selected from a group comprising branched or unbranched saturated aliphatic groups, branched or unbranched unsaturated aliphatic groups, aromatics, anions of carboxylic acids, halogens, stannyl radicals, silyl radicals and π-bonded, unsubstituted or substituted cyclopentadienyl.

10. Component according to one of claims 5 to 9, wherein the electrically semiconducting layer (3) comprises a matrix material in which the rhenium compounds are present as dopants and the rhenium compound and the matrix material form a complex.

11. Component according to one of claims 5 to 10, wherein the electrically semiconducting layer (3) comprises a charge transport/charge injection layer.

12. Component according to one of the preceding claims, wherein the component is a field effect transistor, solar cell or photodetector.

13. A method for producing an electrical organic component according to claims 1 to 12, comprising the process steps
A) providing a substrate (1),
B) generating an arrangement of functional layers on the substrate (1), wherein the arrangement of layers comprises a first electrode (2), an organic functional layer (4) arranged on the first electrode and a second electrode (5) arranged on the functional layer, wherein the first (2) and/or the second (5) electrode comprises polymeric rhenium compounds.

14. The method according to the preceding claim, wherein process step B) comprises:
B1) generation of the first electrode (2) on the substrate (1),
B2) generating the organic functional layer (4) on the first electrode (2),
B3) generating the second electrode (5) on the organic functional layer (4),
wherein in process step B1) and/or in process step B3) monomeric rhenium compounds are condensed onto the substrate (1) and/or onto the organic functional layer (4) and then heated, wherein a polymerization of the rhenium compounds takes place and the first (2) and/or second (5) electrode is formed.

15. Method according to claim 14, wherein in a process step C) that follows process step B1) and/or process step B2) an electrically semiconducting layer (3) is generated on the first electrode (2) and/or on the organic functional layer (4), and wherein rhenium compounds, as dopants, and a matrix material are deposited simultaneously on the first electrode (2) and/or on the organic functional layer (4), wherein the electrically semiconducting layer (3) is formed.

## Revendications

1. Composant électrique organique, comprenant
- un substrat (1),
- une première électrode (2),
- une couche fonctionnelle organique (4) sur la première électrode (2),
et
- une seconde électrode (5) sur la couche fonctionnelle organique (4),
la première électrode (2) et/ou la seconde électrode (5) comportant des composés de rhénium polymères.

2. Composant selon la revendication précédente, dans lequel les oxydes de rhénium polymères sont choisis dans le groupe comprenant le polyalkyltrioxorhénium, le polycy-clopentadiényltrioxorhénium substitué ou non substitué et le polytrioxorhénium ayant au moins un substituant aromatique.

3. Composant selon l'une des revendications précédentes, dans lequel le composant de rhénium est du poly-méthyl-trioxorhénium.

4. Composant selon l'une des revendications 1 à 3, dans lequel les composés de rhénium polymères comportent des agents dopants.

5. Composant selon l'une des revendications précédentes, dans lequel une couche électriquement semi-conductrice (3) dopée existe entre la couche fonctionnelle organique (4) et la première (2) et/ou la seconde électrode (5).

6. Composant selon la revendication précédente, dans lequel la couche électriquement semi-conductrice (3) dopée comprend un agent dopant comprenant des composés de rhénium.

7. Composant selon la revendication précédente, dans lequel l'agent dopant comporte une unité ReO₃ à laquelle est lié un radical M.

8. Composant selon la revendication précédente, dans lequel le radical M est lié σ ou π-lié à l'unité de ReO₃.

9. Composant selon la revendication 7, dans lequel le radical M est choisi dans un groupe comprenant des groupes aliphatiques saturés ramifiés ou non ramifiés, des groupes aliphatiques insaturés ramifiés ou non ramifiés, des aromatiques, des anions d'acides carboxyliques, des halogènes, des radicaux stannyle et un cyclopentadiényle à liaison pi, non substitué ou substitué..

10. Composant selon l'une des revendications 5 à 9, dans lequel la couche électriquement semi-conductrice (3) comprend un matériau matriciel comportant les composés de rhénium sous forme d'agents dopants, les composés de rhénium et le matériau matriciel constituant un complexe.

11. Composant selon l'une des revendications 5 à 10, dans lequel la couche électriquement semi-conductrice (3) comporte une couche de transport de charge/d'injection de charge.

12. Composant selon l'une des revendications précédentes, dans lequel le composant est conçu sous forme de transistor à effet de champ, de cellule solaire ou de photodé-tecteur ou comporte une diode électroluminescente.

13. Procédé de fabrication d'un composant organique électrique selon les revendications 1 à 12, comprenant les étapes suivantes:
A) mise à disposition d'un substrat (1),
B) réalisation d'un agencement de couches sur le substrat (1), l'agencement de couches comprenant une première électrode (2), une couche fonctionnelle organique (4) disposée sur la première électrode et une seconde électrode (5) disposée sur la couche fonctionnelle, la première (2) et/ou la seconde électrode (5) comprenant des composés de rhénium polymères.

14. Procédé selon la revendication précédente, l'étape du procédé B) comprenant:
B1) réalisation de la première électrode (2) sur le substrat (1),
B2) réalisation de la couche fonctionnelle organique (4) sur la première électrode (2),
B3) réalisation de la seconde électrode (5) sur la couche fonctionnelle organique (4),
dans l'étape de procédé B1) et/ou dans l'étape du procédé B3), des composés de rhénium monomères étant condensés sur le substrat (1) et/ou sur la couche fonctionnelle organique (4) et chauffés par la suite, une polymérisation des composés de rhénium ayant lieu et la première (2) et/ou la seconde électrode (5) étant réalisées.

15. Procédé selon la revendication 14, dans lequel, lors d'une étape du procédé C) suivant les étapes du procédé B1) et/ou B2), une couche électriquement semi-conductrice (3) est générée sur la première électrode (2) et/ou sur la couche fonctionnelle organique (4), des composés de rhénium en tant qu'agents dopants et un matériau matriciel étant simultanément déposés sur la première électrode (2) et/ou sur la couche fonctionnelle organique (4), étape pendant laquelle la couche fonctionnelle électriquement semi-conductrice (3) est constituée.
